# FASCICULE DE BREVET EUROPEEN

(11) **EP 1 977 514 B1**
(45) Date de publication et mention de la délivrance du brevet: **15.05.2013**
(21) Numéro de dépôt: 07718323.4
(22) Date de dépôt: 04.01.2007
(51) Int. Cl.: H03K 17/16

(54) **COMMANDE D'UN TRANSISTOR MOS**
STEUERUNG EINES MOS-TRANSISTORS
CONTROLLING A MOS TRANSISTOR

(30) Priorité: 23.01.2006 FR 0600571
(43) Date de publication de la demande: 08.10.2008
(73) Titulaire: VALEO EQUIPEMENTS ELECTRIQUES MOTEUR, 94046 Créteil (FR)
(72) Inventeur: DOFFIN, Hugues, F-94000 Créteil (FR)
(86) Numéro de dépôt international: PCT/FR2007/050610
(87) Numéro de publication internationale: WO 2007/083048

(56) Documents cités:
- EP-A- 0 620 644
- DE-A1- 4 223 274
- US-B1- 6 194 884

## Description

La présente invention concerne la commande d'un transistor, et plus particulièrement un dispositif de commande d'un transistor de puissance (MOSFET). Un exemple d'un tel dispositif est donné dans le document US 6, 194, 884, B1.

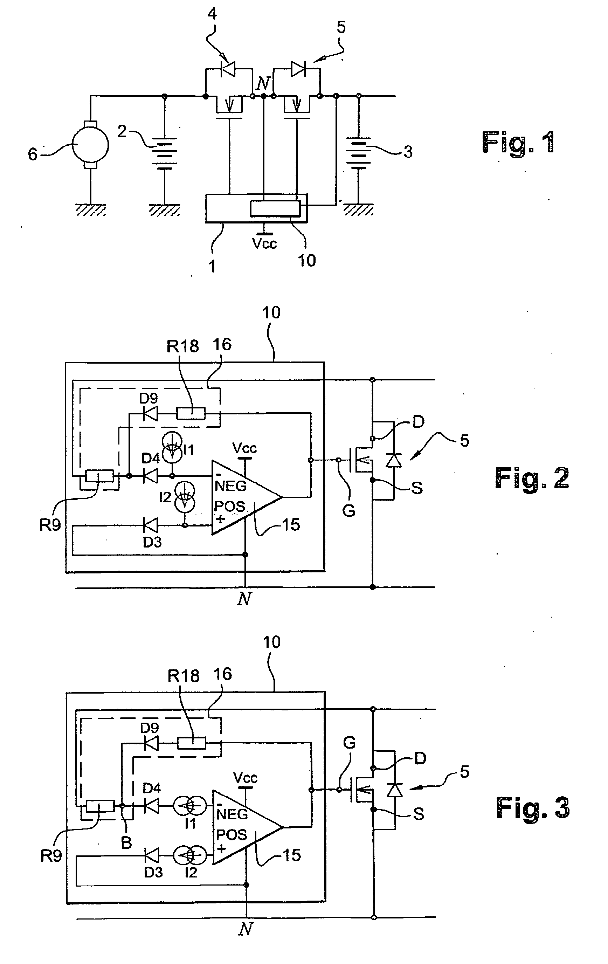

Un tel dispositif de commande est par exemple mis en oeuvre dans le cadre de la charge de batteries en parallèle. Comme illustré à la Fig. 1, une unité de contrôle 1 commande la charge de batteries 2 et 3 par l'intermédiaire de transistors MOS de puissance 4 et 5 dont les chemins de conduction sont disposés en série. La batterie 2 est par exemple connectée à un alternateur 6, démarreur ou alterno-démarreur, et la batterie 3 à des charges non représentées telle qu'un réseau de bord. La batterie 3 est connectée en parallèle avec la batterie 2 par l'intermédiaire des transistors 4 et 5, le transistor 4 étant disposé du côté de la batterie 2 et le transistor 5 étant disposé du côté de la batterie 3. Ces transistors sont commandés par l'unité de contrôle 1 comme des interrupteurs, par exemple sur la base d'un signal de commande externe. Les transistors 4 et 5 sont montés de sorte que leurs diodes parasites sont agencées tête-bêche avec leurs cathodes tournées respectivement vers la batterie 2 et vers la batterie 3. Ainsi, lorsque les deux transistors sont dans l'état bloqué (ouvert), aucun courant ne peut circuler d'une batterie vers l'autre.

Pour charger la batterie 3 par l'alternateur 6, l'unité de contrôle 1 doit commuter le transistor 4 à l'état passant (fermé). Le transistor 5 est maintenu à l'état ouvert, sa diode parasite empêchant la circulation inverse de la batterie 3 vers la batterie 2. Le courant de charge délivré par l'alternateur 6 permet de charger la batterie 2 et passe dans la diode interne du transistor 5 vers la batterie 3, entraînant une chute de tension importante, de l'ordre de 0,7V, en raison de la tension de seuil de la diode. Les deux batteries 2, 3 ne sont donc pas chargées avec la même tension, la batterie 2 étant plus chargée que la batterie 3 à ce moment.

Or, d'un côté, la tension aux bornes de la batterie 3 doit être supérieure à la tension minimale de charge, environ 13V, pour pouvoir la recharger, sinon elle s'abîme. De l'autre, il faut imposer aux bornes de la batterie 2 une tension inférieure à la tension maximale de charge, 15V environ, sinon elle s'abîme également.

Pour respecter les deux conditions, il faut recharger les deux batteries avec la même tension grâce à l'alternateur ou alterno-démarreur 6.

De plus, les pertes dans la diode interne du transistor, égales au produit de la tension seuil et du courant traversant la diode sont importantes, ce qui provoque un échauffement ou dans le pire des cas une détérioration du transistor 5.

La présente invention a notamment pour but de pallier ces inconvénients, à savoir de réduire les pertes joules et de recharger correctement les deux batteries en parallèle.

L'invention propose un dispositif de commande d'un transistor qui permet de limiter les pertes joules et de diminuer la chute de tension aux bornes du transistor.

L'invention propose ainsi un dispositif de commande d'un transistor de puissance formé d'un canal comprenant une grille, une source, et un drain, ledit dispositif comportant :
- un dispositif d'amplification délivrant un signal de commande de sortie pour contrôler la grille du transistor de puissance, ledit dispositif d'amplification comprenant :
- une première entrée reliée au drain du transistor, le tout formant une première portion de circuit, et
- une deuxième entrée reliée à la source du transistor, le tout formant une deuxième portion de circuit.

Conformément à l'invention, le dispositif de commande comporte :
- une boucle de rétroaction avec au moins une résistance (R18) de la sortie vers une des première et deuxième entrées (NEG, POS) ; et
   un moyen pour produire un courant de polarisation (I1,I2), ledit courant étant injecté dans une des dites première et deuxième entrées (NEG, POS) de manière à provoquer un décalage de la mesure de tension drain-source et conserver un régime de fonctionnement linéaire dudit signal de commande de sortie, avant l'ouverture du transistor ;
   caractérisé en ce que le dispositif de commande comporte un même nombre N de jonctions semi-conductrices dans les première et deuxième portions de circuit, N étant un entier au moins égal à 1, et la (les) jonction(s) sur la première portion de circuit est de même nature que celle(s) sur la deuxième portion de circuit.

Ainsi, comme on le verra en détail, on limite les pertes dans le transistor grâce à la commande en régime linéaire et on obtient un décalage de mesure très faible et bien maîtrisé en température grâce au même nombre de jonctions.

Dans divers modes de réalisation non limitatifs du dispositif de commande, on peut éventuellement avoir recours en outre à l'une et/ou à l'autre des dispositions suivantes :
- Le dispositif de commande comporte en outre deux moyens pour produire deux courants de polarisation, les deux courants étant injectés aux entrées du dispositif d'amplification.
- le dispositif de commande comporte en outre un dispositif de protection sur la première portion de circuit.
- Le dispositif de commande comporte en outre un dispositif de protection sur la deuxième portion de circuit.
- Les deux courants de polarisation traversent respectivement les dispositifs de protection des première et deuxième portions de circuit.
- Le courant de polarisation est intégré dans le dispositif d'amplification.
- Le dispositif de commande comporte en outre un dispositif de protection sur la boucle de rétroaction.
- Un dispositif de protection comporte une diode.
- Un dispositif de protection comporte un interrupteur.
- Les courants de polarisation sont réalisés par un miroir de courant.
- Les courants de polarisation sont égaux.
- Les courants de polarisation sont différents.
- La première entrée du dispositif d'amplification est l'entrée négative et la deuxième entrée est l'entrée positive.
- Le dispositif d'amplification comprend un premier étage d'amplification pour amplifier la tension d'entrée du dispositif d'amplification.
- Le courant de polarisation traverse le premier étage d'amplification.
- Le dispositif d'amplification comprend en outre un deuxième étage d'amplification pour amplifier la tension du premier étage d'amplification.
- Le dispositif d'amplification comporte en outre un troisième étage d'amplification comportant un gain en courant important de façon à commander rapidement le transistor.
- Ledit troisième étage d'amplification comprend un circuit de décharge rapide du transistor.
- Le circuit de décharge comprend des moyens pour décharger jusqu'à sensiblement zéro la grille du transistor.
- Ledit troisième étage d'amplification comprend un circuit de charge du transistor.
- le dispositif d'amplification comporte en outre un étage de commande supplémentaire pour commander en tout ou rien un transistor de puissance.
- L'étage de commande en tout ou rien utilise le troisième étage d'amplification.
- Le dispositif de commande est réalisé dans un circuit intégré comprenant ou non ledit transistor de puissance.

L'invention porte également sur un système de gestion de deux batteries pour véhicule automobile, comportant une unité de commande comprenant un dispositif de commande de transistor de puissance, ladite unité étant destinée à mettre en parallèle les batteries, le dispositif de commande étant caractérisé selon l'une des caractéristiques précédentes.
- Le dispositif de commande dans le système de gestion de batterie comporte une commande d'un transistor de puissance en tout ou rien.

L'invention porte également sur un pont de puissance pour machine électrique tournante comprenant des transistors de puissance associés à des phases d'un stator de ladite machine, chaque transistor étant commandé par un dispositif de commande selon l'une des caractéristiques précédentes.

L'invention porte également sur une machine électrique tournante comprenant un dispositif de commande d'un transistor de puissance selon l'une des caractéristiques précédentes.
- Le transistor de puissance de la machine électrique tournante permet de piloter ladite machine en mode moteur.

D'autres particularités et avantages de la présente invention apparaîtront dans la description ci-après d'exemples de réalisation non limitatifs, en référence aux dessins annexés, dans lesquels :
- la Fig. 1, déjà décrite, est un schéma d'un premier exemple d'application dans lequel un dispositif conforme à l'invention peut être utilisé ;
- la Fig. 2 est un premier schéma fonctionnel du dispositif conforme à l'invention ;
- la Fig. 3 est un deuxième schéma fonctionnel du dispositif conforme à l'invention ;
- la Fig. 4 est un schéma d'un exemple de réalisation d'un dispositif de commande du dispositif de commande conforme à l'invention ;
- la Fig. 5 est un schéma simplifié de l'exemple de réalisation de la Fig. 4 ;
- la Fig. 6 représente une courbe de la tension grille-source en fonction de la tension drain-source d'un transistor commandé par le dispositif de commande selon la Fig. 5 ; et
- la Fig. 7 représente deux courbes schématiques du courant drain-source et de la tension drain-source d'un transistor commandé par le dispositif de commande selon la Fig. 5, en fonction d'un temps de commutation du transistor.
- la Fig. 8 est un troisième schéma fonctionnel du dispositif conforme à l'invention ;
- la Fig. 9 est un schéma d'un exemple de réalisation d'un dispositif de commande conforme à l'invention;
- la Fig. 10, est un schéma d'un deuxième exemple d'application dans lequel un dispositif conforme à l'invention peut être utilisé ;

Le dispositif de commande 10 d'un transistor peut être mis en oeuvre dans le dispositif de charge de batterie illustré à la Fig. 1.

Dans la suite de la description, il est décrit dans le cadre de cette application. Bien entendu, ladite application n'est qu'un exemple d'application non limitatif pour ledit dispositif de commande. Ledit dispositif peut être utilisé dans d'autres applications comme on le verra en détail plus loin.

On installe le dispositif de commande 10 pour commander de manière autonome le deuxième transistor 5, le premier transistor 4 étant commandé par un signal externe, en commande tout ou rien. Dans un mode non limitatif, le transistor 5 est un transistor MOSFET. Il en est de même pour le transistor 4.

Selon le premier schéma fonctionnel de la Fig. 2, le dispositif de commande 10 comporte :
- un dispositif d'amplification 15 pour contrôler la grille du transistor 5 via un signal de commande de sortie,
- une boucle de rétroaction 16 de la sortie du dispositif d'amplification vers une de ses entrées, on notera que cette boucle de rétroaction peut être non pas sur la sortie, mais à l'intérieur du dispositif d'amplification. Ce deuxième mode permet de mieux stabiliser le circuit du dispositif d'amplification 15,
- au moins un courant de polarisation I1, et
- une première résistance R9.

Ces éléments sont décrits plus en détail ci-après.

### ● Dispositif d'amplification 15

Le dispositif d'ampliflcation 15 comporte :
- une première entrée NEG (-) reliée au drain du transistor via une première résistance R9, le tout formant une première portion de circuit,
- une deuxième entrée POS (+) reliée à la source du transistor, via ici un point N relié à une unité de contrôle 1,

Dans un mode de réalisation non limitatif, la première entrée NEG du dispositif d'amplification 15 est l'entrée négative, et la deuxième entrée POS est l'entrée positive.

Dans une autre variante, cela peu être l'inverse. A ce moment, la boucle de rétroaction 16 comporte un inverseur.

### ● Boucle de rétroaction 16

Dans un exemple de réalisation non limitatif, la boucle de rétroaction comporte :
- une première résistance R9,
- unie deuxième résistance R18.

Dans un mode de réalisation non limitatif, la boucle de rétroaction 16 est couplée sur l'entrée négative NEG du dispositif d'amplification 15. Cette boucle de rétroaction permet de maîtriser la fonction de transfert du dispositif d'amplification 15, notamment le gain en réinjectant un courant de rétroaction Iret.

Dans un mode de réalisation non limitatif, ladite boucle 16 comporte en outre une diode de protection D9 contre une tension drain importante, ici, 12V, et contre un courant de fuite provenant du drain et risquant de décharger la batterie 3.

### ● Courant de polarisation

Le courant de polarisation I1 est couplé à une des entrées du dispositif d'amplification 15. Dans un mode de réalisation non limitatif il y a deux courants de polarisation I1, I2 couplés respectivement aux deux entrées NEG, POS du dispositif d'amplification 15.

De plus, dans un mode de réalisation préférentiel non limitatif, les courants de polarisation I1, 12 sont intégrés dans le dispositif d'amplification 16, comme indiqué sur la Fig. 3. Ils vont ainsi servir également à l'amplification effectuée par le dispositif d'amplification 15 comme on le verra en détail plus loin. Ainsi, il n'est pas nécessaire d'ajouter un circuit externe.

Dans un mode de réalisation non limitatif, les courants de polarisation I1, I2 sont réalisés par deux sources de courant.

Dans une autre variante, lesdits courants peuvent être réalisés par une résistance reliée à un potentiel fixe.

### ● Résistance R9

Les courants de polarisation 11, I2 permettent en combinaison avec la résistance R9 d'effectuer un décalage de la mesure de tension drain-source pour que le dispositif d'amplification 15 ouvre (tension grille-source nulle Vgs) le transistor 5 quand sa tension drain-source est nulle Vds. Ainsi, pour obtenir ce décalage en tension, on fait varier soit les courants de polarisation, soit la valeur de la résistance R9.

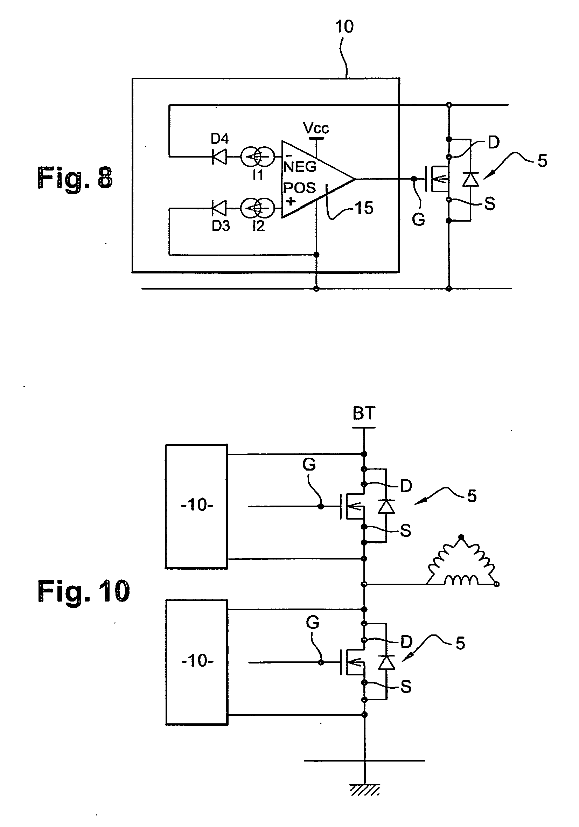

Pour l'application batterie, dans un exemple de réalisation, le décalage de la mesure de tension se situe entre 30mV et 40mV, comme on le verra en détail plus loin. On notera que cette résistance R9 peut être égale à zéro. Dans ce cas, la boucle de rétroaction se trouve à l'intérieur du dispositif d'amplification comme on le verra par la suite en détail dans un troisième schéma fonctionnel illustré à la Fig. 8.

### ● Dispositif de protection D

Dans un mode de réalisation préférentiel non limitatif, le dispositif de commande 10 comporte en outre un dispositif de protection D couplé à une entrée du dispositif d'amplification 15 pour empêcher le passage d'un courant de fuite du drain dans la boucle de rétroaction 16 et dans le dispositif d'amplification 15.

Un tel dispositif de protection D peut comprendre :
- Soit, dans un mode de réalisation non limitatif, trois diodes D4, D3, D9 respectivement sur chacune des entrées NEG, POS avant le point B (point reliant la première résistance R9 à la première entrée NEG du dispositif d'amplification), et la boucle de rétroaction 16, comme illustré sur la Fig. 3,
- Soit un interrupteur (non représenté) remplaçant chaque diode citée ci-dessus,
- Soit uniquement un interrupteur sur la première portion de circuit, entre le drain et la première résistance R9. Cet interrupteur combiné avec le courant de polarisation I1 sortant du dispositif d'amplification 15 et allant vers le drain permet de réaliser la fonction suivante :
   Lorsque l'interrupteur est fermé, le système fonctionne comme le montage décrit à la Fig. 3.
   Lorsque l'interrupteur est ouvert, le courant de polarisation qui ne peut plus traverser la première portion de circuit permet d'ouvrir le MOS car le potentiel sur l'entrée négative NEG devient supérieur au potentiel sur l'entrée positive POS du dispositif d'amplification 15.

On notera que lesdites diodes D4, D3, D9 sont placées là où il y a des courants de fuite lorsque le dispositif est éteint. Ainsi, la disposition de la Fig. 3 est un cas préférentiel parmi d'autres. Par exemple, on pourrait avoir les diodes D4, D3 directement connectées à la source et au drain du transistor 5 après le noeud B (avant ou après la résistance R9), tandis que la boucle de rétroaction 16 serait directement reliée au dispositif d'amplification 15.

On pourrait également remplacer les diodes par des transistors MOSFET.

Les deux courants de polarisation I1, I2 traversent respectivement les deux diodes D4, D3 reliées au deux entrées NEG, POS du dispositif d'amplification 15.

Dans un premier mode de réalisation, on règle les courants de polarisation de manière à avoir les mêmes tensions de conduction dans lesdites diodes et dans les transistors T2 et T1 (décrits plus loin) du dispositif d'amplification 15 de manière à ce que lesdites diodes et le dispositif d'amplification 15 n'induisent pas de décalage en tension. Ainsi, on supprime le décalage « offset » complémentaire qui décalerait davantage la mesure en tension drain-source du transistor 5. Cet offset complémentaire non maîtrisé pourrait en effet induire une erreur sur la tension drain-source que l'on veut obtenir. On peut par exemple prendre des courants de polarisation I1 et 12 identiques et constants pour toute tension d'alimentation du dispositif de commande, et les diodes D3 et D4 identiques.

Dans un deuxième mode de réalisation, on règle les courants de polarisation de manière à avoir cette fois un décalage « offset » complémentaire maîtrisé qui varie en fonction de la température des diodes et du dispositif d'amplification 15 (notamment les transistors T2 et T1 décrits plus loin).

Ce décalage, est choisi en fonction de la variation en température de la résistance inteme du transistor MOS 5. On le choisit de manière à ce qu'il augmente lorsque la température augmente. Ce deuxième mode permet ainsi d'obtenir un fonctionnement en mode linéaire avant l'ouverture du transistor MOS 5 même à des températures élevées car le transistor a sa résistance interne qui augmente avec la température. En conséquence, on avance l'instant où on décharge la grille du transistor 5. Ainsi la grille du transistor 5 a le temps de se décharger correctement avant que le courant ne s'inverse dans ledit transistor 5. Ainsi, on limite les parasites électromagnétiques. On peut par exemple prendre des courants de polarisation I1 et I2 différents et les diodes D3 et D4 identiques.

Ainsi, le pilotage de la grille en régime linéaire est plus efficace que le pilotage en tout ou rien. Car un des problèmes du pilotage en tout ou rien par un comparateur est que lorsque le transistor est passant et le courant drain-source Ids est faible, la tension drain-source devient très faible ce qui donne lieu :
- soit à des oscillations car on est à la limite de l'offset du comparateur,
- soit à un courant qui peut circuler de la batterie 3 à la batterie 2.

On évite les oscillations en pilotant la grille du transistor de façon à adapter son canal au courant drain-source Ids qui le traverse.

Ainsi, grâce aux diodes D3 et D4, et éventuellement aux courants de polarisation I1 et I2 associés (cas de la Figure 2 par exemple où les courants sont externes au dispositif d'amplification 15), on obtient un nombre N égal de jonctions semi-conductrices entre les entrées drain et source du transistor 5 et le premier étage du dispositif d'amplification 15. Donc, ici N = 1. Cela permet ainsi d'avoir un décalage de mesure tension drain-source très faible (de l'ordre de 40mV) par rapport à la tension d'une diode (de l'ordre de 0,7V). On a donc moins de pertes joules et donc un meilleur rendement de la machine. On notera que N peut être égal à 0 dans le cas où il n'y a pas de diodes de protection D3 et D4, mais uniquement la résistance R9 avec au moins le courant de polarisation I1. Même dans ce cas, on a un nombre égal de jonctions.

De plus, en choisissant des composants de même nature sur les deux entrées (diode D4-diode D3 et courant I1-courant I2), on peut facilement les choisir avec les mêmes caractéristiques et donc obtenir une bonne symétrie sur les deux entrées. Cela permet de régler facilement le décalage de mesure de tension drain-source, soit en fonction de la température (quand I1 différent de 12), soit à une valeur constante donnée (11 égal 12).

En conséquence, grâce au nombre égal de jonctions semi-conductrices et à cette symétrie (composants de même nature), il est facile de choisir le décalage de mesure même avec une valeur très faible sans que des tensions de décalages complémentaires provenant desdits composants choisis et générées par des dérives en température n'interviennent.

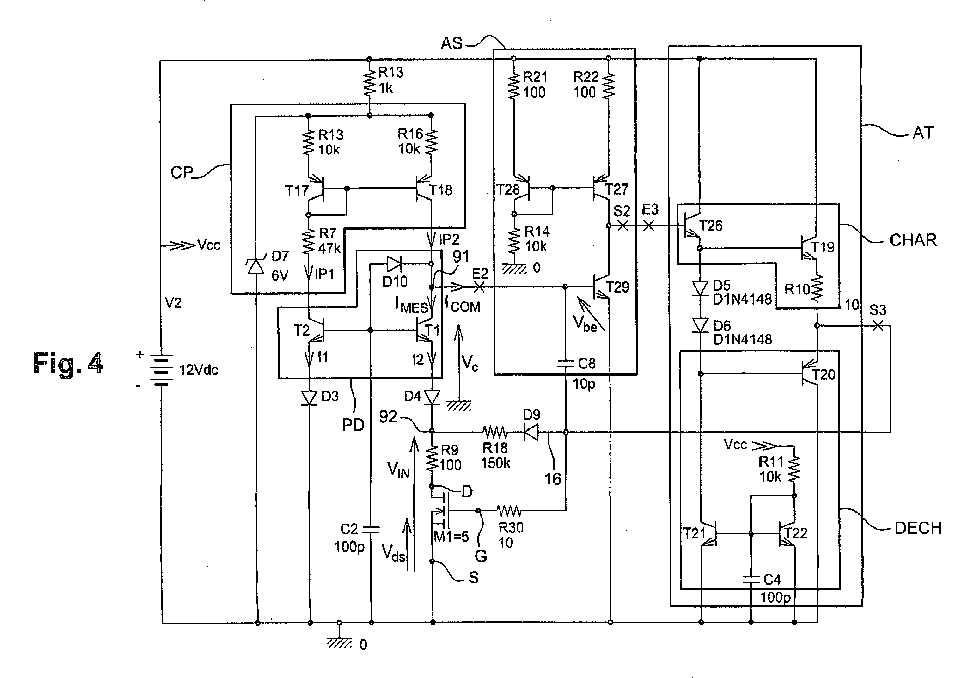

La Fig. 4 présente un exemple de réalisation non limitatif du dispositif de commande 10 et ses éléments cités précédemment. Ses éléments sont ainsi décrits en détail ci-après selon cet exemple de réalisation.

### ● Dispositif d'amplification 15

Le dispositif d'amplification 15 comprend :
- Un premier étage d'amplification PD,
- un deuxième étage d'amplification AS, et
- un troisième étage d'amplification AT.

Ces trois éléments sont décrits en détail ci-après.

### o premier étage d'amplification PD :

Il permet d'amplifier la tension d'entrée Vin du dispositif d'amplification 15, soit la tension drain-source plus la tension aux bornes de la première résistance R9.

Le premier étage PD comporte deux transistors T1, T2 dont les bases sont reliées entre elles. Ceci, afin de rendre symétrique ce premier étage, de sorte qu'il n'y ait pas de décalages entre les tensions base-émetteur plus tension diode des branches des deux transistors et diodes associées D4, D3.

Dans un mode de réalisation non limitatif, ces transistors sont des transistors bipolaires, et NPN. On peut les choisir selon la technologie PNP si on le désire.

Dans une autre variante, ces transistors sont des Jfets.

Par ailleurs, dans un mode de réalisation non limitatif, les courants de polarisation I1, I2 traversent le premier étage PD, comme illustré sur la Fig. 4.

Ainsi, les émetteurs des transistors T1, T2 du premier étage envoient les courants de polarisation I1, I2 dans les diodes D4, D3, du dispositif de protection D.

Cela présente les avantages suivants :
- Cela permet d'obtenir un fort courant à l'entrée de l'étage PD, de l'ordre de 100µA pour l'application batterie notamment. Ainsi, cela simplifie le schéma du dispositif d'amplification, puisqu'il n'est pas nécessaire d'amplifier le courant en même temps que la tension d'entrée Vin (un fort courant étant nécessaire pour commander le transistor 5, de l'ordre de 1A), et donc il n'est pas nécessaire d'avoir des composants supplémentaires pour amplifier ledit courant,
- Par ailleurs, on utilise le même courant pour faire le décalage
   « offset » en tension et l'amplification de la tension d'entrée Vin (Un courant de polarisation I2 se retrouvant en partie dans la résistance R9). On évite ainsi une trop grande consommation en courant qui interviendrait si on avait pris deux courants distincts,
- Le fait d'utiliser un fort courant pour l'entrée du dispositif d'amplification 15, évite d'être sensible aux parasites dus aux portions de circuit entre le transistor 5 et le dispositif de commande 10, évitant ainsi d'avoir des composants supplémentaires de filtrage tel qu'une capacité de filtrage, et
- Grâce au courant important, la résistance dynamique des diodes D4, D3 est plus faible, donc la réponse en fréquence de l'étage PD est plus rapide de sorte que le montage du dispositif de commande dans son ensemble est plus rapide.

On notera que la paire différentielle PD comporte en outre dans un mode de réalisation non limitatif :
- une diode D10 relié entre le collecteur et la base du premier transistor T1 du premier étage qui permet d'éviter la saturation de T1 qui pourrait provoquer un retard lors de la montée de la tension collecteur.

### o Deuxième étage d'amplification AS :

Le deuxième étage d'amplification AS permet d'amplifier de nouveau la tension d'entrée Vin=Vds+R9*(I1+Iret). Il permet ainsi d'augmenter le gain en tension.

Ledit deuxième étage AS comprend dans un mode de réalisation non limitatif :
- Un troisième transistor T29,
- Une source de courant pour polariser le transistor T29

Ce troisième transistor T29 permet de limiter la tension de sortie Vc du premier étage (tension collecteur de T1). Dans un exemple non limitatif, cette limite est fixée à 0,7V.

Ainsi, si on a une tension drain-source Vds entre -1V et -0,04V, la tension de sortie Vc du premier étage PD varie entre -1V et 0,7V (sans diode D4), et entre -0,3V et 0,7V (avec la présence de la diode D4).

Donc, on peut voir qu'avec la diode de protection D4, la tension de sortie Vc est plus proche de la tension Vbe (environ égale à 0,7V) du troisième transistor T29 de sorte que lorsque ce transistor T29 passe d'un état à un autre (ouvert/fermé), il le fait plus rapidement. Ce gain en rapidité se reporte sur la commande du transistor 5.

On notera qu'on peut introduire une capacité C8 entre la base du troisième transistor T29 et la grille du transistor 5 pour stabiliser les derniers étages d'amplification dont celui-ci.

On notera que la source de courant peut être réalisée par un miroir de courant T28-T27-R14 avec les avantages cités plus loin avec deux résistances R21, R22 associées pour atténuer les différences entre les composants du miroir.

### o Troisième étage d'amplification AT :

Le troisième étage d'amplification AT permet de délivrer un courant de sortie suffisant pour charger ou décharger rapidement la grille G du transistor 5. Ledit troisième étage comporte ainsi des moyens pour décharger DECH jusqu'à sensiblement zéro la grille G du transistor 5, cela, afin d'être sûr que le transistor 5 arrive bien à s'ouvrir quand le dispositif de commande 10 essaye de l'ouvrir, sinon il risque de griller.

En outre le troisième étage comporte des moyens de charge CHAR.

Lesdits moyens de décharge DECH comportent dans un mode de réalisation non limitatif :
- un miroir de courant T21-T22-R11 auquel est associé si nécessaire un condensateur C4 pour la stabilité, et
- un quatrième transistor T20 comportant, dans un exemple non limitatif, un gain d'au moins 100.

Le miroir de courant T21-T22-R11 est utile pour moins consommer par rapport à une simple résistance.

Les moyens de charge CHAR comportent :
- un cinquième transistor T19 avec une résistance R10 servant de protection contre un surcourant, et
- un sixième transistor T26.

Le troisième étage AT comporte en outre dans un mode de réalisation non limitatif :
- des diodes D5, et D6, et
- une résistance de sortie R30 permettant d'ajuster la stabilité du dispositif de commande 10,

Les diodes D5, et D6 permettent aux cinquième et sixième transistors T19 et T20 de conduire en même temps, ce qui limite des retards et des problèmes d'oscillations.

On notera que la charge du transistor 5 se fait rapidement grâce :
- à l'obtention de courants importants, par exemple de 0,2 à 1A, le troisième étage AT ayant dans un mode de réalisation non limitatif un fort gain en courant, ici de l'ordre de 1000, T26, et T19 ayant un gain de l'ordre de 100, et
- à la rapidité des étages précédents PD et AS, et
- au montage suiveur comprenant les transistors T26 et T19.

On notera que la décharge du transistor 5 se fait rapidement grâce :
- à l'obtention de courants importants, par exemple de 0,2 à 1A, le troisième étage AT ayant dans un mode de réalisation non limitatif un fort gain en courant, et T20 ayant un gain de l'ordre de 100, et
- à la rapidité des étages précédents PD et AS, et
- au miroir de courant T21-T22-R11 en combinaison avec le quatrième transistor T20, ladite combinaison permettant une décharge plus rapide par rapport à une simple résistance qui ne pourrait être faible sans consommer trop de courant.

On notera par ailleurs que la combinaison miroir de courant T21-T22-R11 avec le quatrième transistor T20 permet de décharger jusqu'à sensiblement zéro, ici 0,7V = Vbe du quatrième transistor T20, la grille du transistor. Ainsi, on limite l'influence de l'effet Miller bien connu de l'homme du métier, qui crée une impulsion de tension sur la grille du transistor 5 lorsque la tension drain-source Vds varie de manière rapide. Cette impulsion peut provoquer une commutation non désirée ou perturber la commande dudit transistor 5.

### ● Courants de polarisation

Par ailleurs, on notera que les sources de courants CP réalisant les courants de polarisation I1, I2 sont réalisées par, comme illustré à la Fig. 4 :
- un miroir de courant T17-T18- R7, et
- dans un mode de réalisation non limitatif deux résistances R13 et R16 associées audit miroir afin d'atténuer les différences entre les composants du miroir. On notera que ces résistances peuvent avoir une forte valeur car on n'a pas besoin d'une tension de sortie Vc élevée à la sortie du premier étage d'amplification PD, comme on le verra par la suite.

Ainsi, grâce au miroir de courant, le premier courant 11 est réalisé à partir du deuxième courant I2. Les courants de polarisation sont donc simples à réaliser. De plus, cela permet d'avoir les mêmes tensions de conduction dans lesdites diodes de protection D3, D4.

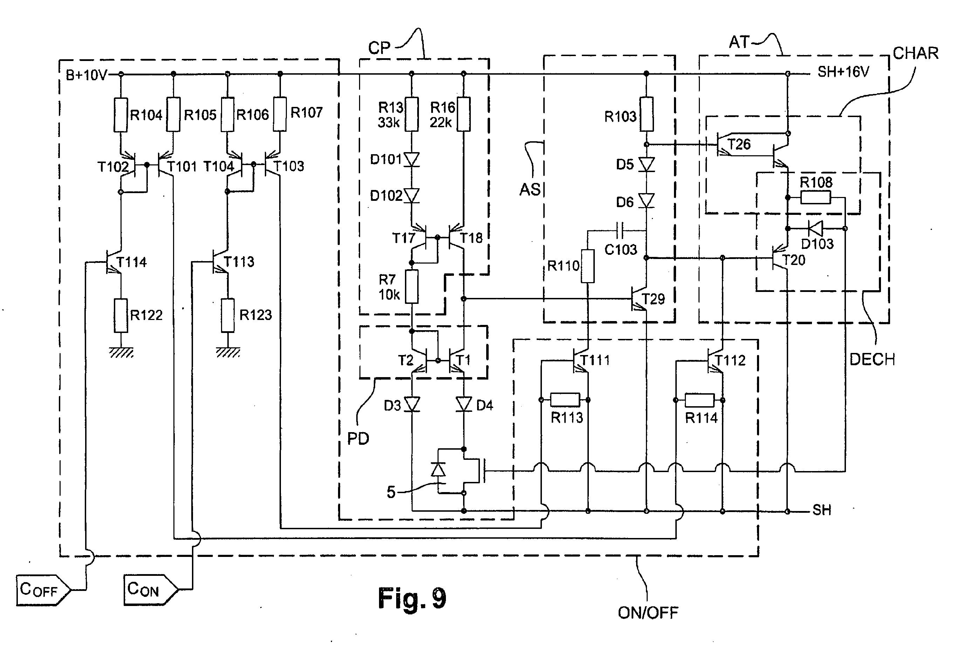

On notera que, dans un mode de réalisation, on peut prévoir qu'une source de courant est fabriquée à partir d'une source de tension, ici représentée par une diode zener D7 de manière à avoir une valeur fixe du décalage de mesure de tension, ici entre 30mV et 40mV. Dans le cas contraire, ce décalage varie en fonction de la tension d'alimentation Vcc, qui est ici de 12V. On notera que la source de courant peut être réalisée en ajoutant en série avec la résistance R13 une ou plusieurs diodes de manière à garantir un décalage de mesure de tension qui ne tend pas vers zéro lorsque la tension d'alimentation Vcc décroît jusqu'à zéro de sorte que le dispositif ne commande pas le transistor 5 de manière intempestive quand la tension d'alimentation est faible, environ 3V par exemple. Cette réalisation est illustrée à la Fig. 9

### ● Boucle de rétroaction 16

Par ailleurs, la boucle de rétroaction 16 comporte de façon non limitative :
- une résistance R18 permettant une limitation dans le gain de ladite boucle à environ 1000 avec les valeurs données (R18/R9) permettant de stabiliser le système.

Ainsi, on a un gain total du dispositif de commande 10 qui est fonction de ce rapport de résistances R18/R9 et qui est donc quasiment fixe.

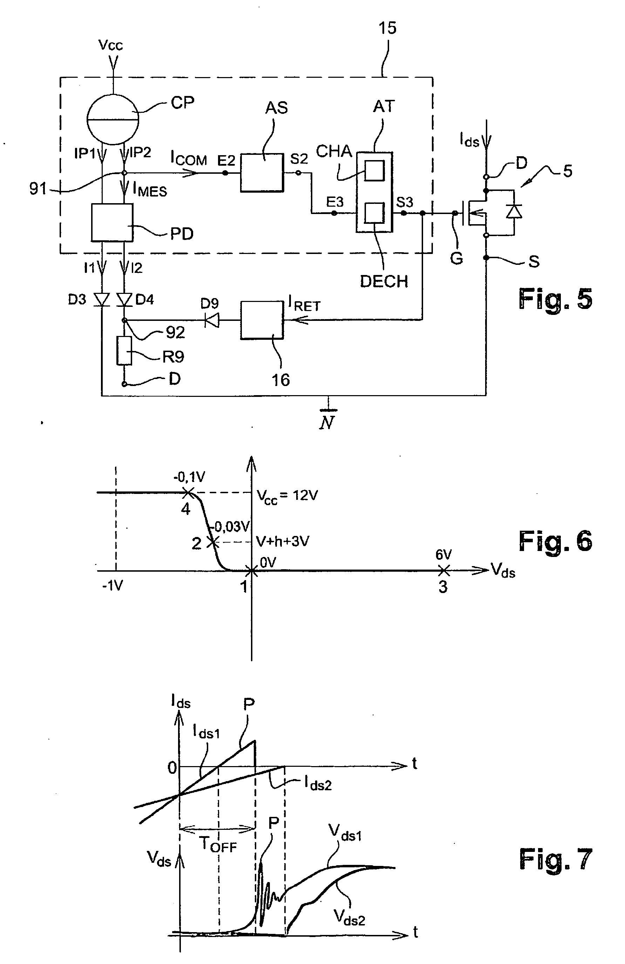

En référence à la Fig. 5, les branchements des différents éléments du dispositif d'amplification 15 sont effectués comme suit.

Les sources de courants CP sont alimentées par une borne d'alimentation portée à une tension d'alimentation Vcc. Elles sont par ailleurs connectées, au niveau du noeud 91, à une branche de mesure comprenant le premier étage PD et à une branche de commande comprenant le deuxième étage d'amplification AS.

Le premier étage PD comprend en outre une sortie connectée aux diodes de protection D4, D3.

Le deuxième étage d'amplification AS comprend une entrée E2 connectée à une sortie du premier étage PD, au niveau du noeud 91, et une sortie S2 connectée à une entrée E3 du troisième étage d'amplification AT.

Le troisième étage d'amplification AT comporte une sortie S3 connectée à la grille G du transistor 5.

Enfin, la boucle de rétroaction 16 est connectée à la grille G d'une part du transistor 5 comme décrit précédemment et à la branche de mesure d'autre part, au niveau du noeud 92.

Par ailleurs, les courants parcourant les différents éléments du dispositif d'amplification 15 sont illustrés comme suit.

Au niveau du noeud 91, le courant de polarisation IP2 est égal à la somme des courants Imes et Icom parcourant respectivement la branche de mesure et la branche de commande, et IP1+Imes = I1+I2.

On notera que par abus de langage on a appelé indifféremment les courants de sortie IP1, IP2 du miroir de courant et les courants I1, I2 sortant des émetteurs des premier et deuxième transistors T1, T2, courants de polarisation.

La branche de commande est ainsi parcourue par le courant de commande Icom, tandis que la boucle de rétroaction 16 est parcourue par le courant de rétroaction Iret = Ugrille/R18.

Le fonctionnement du dispositif de commande 10 est décrit ci-après. Il est décrit dans le cadre d'un fonctionnement d'un interrupteur reliant deux batteries. Ce fonctionnement est un exemple non limitatif.

### ● Au niveau des batteries :

Dans une première étape INIT), dans un état initial, le système décrit à la Fig. 1 est au repos et aucun courant ne passe entre les deux batteries. Cette configuration correspond à un véhicule à l'arrêt sans aucun consommateur électrique.

Dans une deuxième étape +APC), quand l'utilisateur met la clé de contact, un courant (environ 20A) est consommé sur la batterie 3. Ce courant produit une chute de tension aux bornes de ladite batterie et le dispositif de commande 10 vient piloter le transistor 5 de façon à réduire la chute de tension.

Dans une troisième étape +DEM), lorsque l'utilisateur vient démarrer le moteur thermique par l'intermédiaire d'un démarreur ou d'un alterno-démarreur, le courant est prélevé sur la batterie 2, par exemple de l'ordre de 600A. Ce courant important fait chuter la tension aux bornes de la batterie 2 de façon considérable (de 12V à 6V par exemple). Pour éviter que cette chute de tension ne vienne perturber le réseau de bord connecté à la batterie 3, il est souhaitable que le dispositif de commande 10 ouvre le transistor 5 rapidement. Une commande rapide permet aussi de protéger le transistor 5 contre un risque éventuel d'échauffement thermique important qui risque de griller ledit transistor. On notera que la commande du transistor 4 s'effectue au moyen d'un signal externe.

Dans une quatrième étape ALT), lorsque le moteur thermique est démarré, l'alternateur ou alterno-démarreur fournit du courant pour recharger les batteries 2 et 3, et le transistor 5 doit se fermer pour éviter les échauffements et pour maintenir les mêmes tensions de charge sur les deux batteries sans quoi la batterie 2 sera plus chargée que la batterie 3.

Les étapes ci-dessus sont décrites plus en détail ci-après.

### ● Au niveau du dispositif de commande 10

Dans la première étape INIT), l'unité de contrôle 1 et donc le dispositif de commande 10 ne sont pas alimentés, les deux transistors 4 et 5 ne sont pas commandés. La tension grille Vg = 0. Les tensions des deux batteries 2 et 3 sont aux alentours de 12,8V.

Dans la deuxième étape +APC), l'unité de contrôle 1 est alimentée par Vcc et donc le dispositif de commande 10 également. Le transistor 4 est donc commandé et passant. La tension de la batterie 3 devient plus faible (12,5V) que celle de la batterie 2, cette chute de tension se reporte sur la tension drain-source Vds du transistor 5 et est négative, d'environ -0,3V par exemple. Le courant drain-source Ids est quasiment nul.

La tension grille Vg étant nulle, le courant de rétroaction Iret est nul.

On a le courant de polarisation I2 qui traverse la première résistance R9, soit on a une tension Vr9 d'environ 60mV ce qui est petit devant Vds.

Comme la tension base-émetteur Vbe = 0,7V, le transistor T1 conduit à fond et Vc = Ve = 0,4V.

L'entrée E2 du deuxième étage AS passe donc à 0,4V et le troisième transistor T29 ne conduit pas.

Donc l'entrée E3 du troisième étage AT passe à Vcc - 0,7V, et la grille du transistor 5 se charge par les moyens de charge CHAR (T26 et T19 deviennent passants, ce qui charge la grille du transistor 5). Ledit transistor est ainsi fermé.

A ce moment, le courant drain-source Ids augmente jusqu'à environ 10A en valeur absolue (-10A), le courant consommé sur chacune des batteries 2 et 3 étant maintenant d'environ 10A sur chacune.

A ce moment également, la boucle de rétroaction 16 injecte un courant de rétroaction Iret dans le premier étage PD. Ce courant permet d'améliorer la stabilité du dispositif de commande 10.

On notera que la pente de variation du courant drain-source Ids dépend ici des inductances de câblage reliant les deux batteries.

Dans la troisième étape +DEM), la tension de la batterie 2 devient plus faible (6,5V) que celle de la batterie 3 (12,5V), cette chute de tension se reporte sur la tension drain-source Vds du transistor 5 et est positive, d'environ 6V par exemple.

On a le courant de rétroaction Iret qui traverse la première résistance R9, la tension résultante étant négligeable devant 6V.

Le premier transistor T1 est complètement ouvert.

Le courant de polarisation IP2 ne passe plus dans le transistor T1, donc Icom=IP2 et donc le troisième transistor T29 est passant.

L'entrée E3 du troisième étage AT devient nulle, donc les transistors T26 et T19 sont bloqués.

En conséquence, la grille se décharge dans le dispositif de décharge DECH. Le transistor 5 s'ouvre et le courant drain-source passe de 10A à 0A en valeur absolue (-10A à OA).

Aucun courant ne circule de la batterie 3 vers la batterie 2. Il n'y a donc pas eu de creux de tension sur le réseau connecté à la batterie 3, un tel creux pouvant éteindre certains équipements. On a donc protégé le réseau de bord.

On notera que la pente de variation du courant drain-source dépend ici des inductances du démarreur.

Dans une quatrième étape ALT), l'alternateur régule la tension à ses bornes, à 14V, ce qui charge la batterie 2 à 14V. La différence de tension Vds est à 0,8V due au passage du courant dans la diode du transistor 5. La batterie 3 est donc rechargée à 13,2V. Or il faut la recharger à 14V, ce que fait le dispositif de commande 10 de façon autonome comme indiqué dans la deuxième étape +APC. Lorsqu'il existe des consommateurs de forte puissance sur le réseau de bord, le courant drain-source Ids augmente en valeur absolue jusqu'à 100A environ et la tension grille-source Vgs atteint sa valeur maximale, environ Vcc, ledit courant Ids étant fourni par l'alternateur.

La tension grille-source Vgs est représentée en fonction de la tension drain-source Vds sur la Fig. 6. Sur cette courbe, les différentes étapes décrites précédemment sont représentées lorsqu'on est en régime stabilisé.

La première étape INIT est représentée par le point 1.

La deuxième étape +APC est représentée par le point 2.

La troisième étape +DEM est représentée par le point 3.

La quatrième étape ALT est représentée par le point 4.

On peut ainsi voir que le dispositif de commande 10 et donc le dispositif d'amplification 15 fonctionne en régime linéaire lors de la deuxième étape +APC, c'est-à-dire avant d'ouvrir le transistor 5. Ceci permet d'augmenter la rapidité de l'ouverture du transistor par rapport à un cas où la tension grille-source Vgs serait égale à Vcc (transistor 5 complètement passant).

On notera que la boucle de rétroaction 16 intervient de la manière suivante pour les deuxième +APC et quatrième étapes ALT. Le courant de rétroaction Iret, fonction de la tension grille Vg est réinjecté dans le dispositif d'amplification 15 de sorte que le gain du dispositif d'amplification 15 est limité, aux environs de 1000, améliorant ainsi la stabilité du dispositif de commande. Ainsi, lorsque la tension drain-source Vds est au voisinage de -30mV, on évite d'autant plus une commutation du transistor en tout ou rien (Vgrille-source = 0V ou Vcc). Ainsi, on fait varier le canal du transistor 5 en pilotant la tension grille-source Vgs en fonction des tensions Vds et Vgs (via la boucle de rétroaction 16).

Pour les première INIT et troisième +DEM étapes, le courant de rétroaction Iret est nul, la tension grille-source Vgs étant nulle.

Ainsi, le courant de polarisation I1 traversant la première résistance R9 permet d'effectuer le décalage de mesure en tension de l'ordre de 30mV de sorte que le dispositif d'amplification fonctionne en régime linéaire avant d'ouvrir le transistor 5. Sans la résistance R9 (si R9=0 par exemple), la courbe de la tension Vgs en fonction de la tension Vds serait une courbe d'un comparateur centrée sur 0. De ce fait, la tension Vgs chuterait directement à 0 et le transistor 5 n'aurait pas le temps de s'ouvrir avant que Vds ne devienne positive et donc une inversion d'Ids (négatif à positif).

On notera que le dispositif de commande 10 permet de commander le transistor 5 en régime linéaire notamment comme on l'a vu précédemment sur la Fig. 6.

Cependant, on remarquera qu'un tel dispositif peut également commander un transistor en commande tout ou rien, et notamment le transistor 5. Dans ce cas, on utilise un dispositif de commande 10 selon un deuxième exemple de réalisation, comme illustré à la Fig. 9 que l'on va voir. Le fait de pouvoir sélectionner le type de commande du transistor 5 (soit en linéaire, soit en tout ou rien)

La Fig. 8 illustre un troisième schéma fonctionnel du dispositif de commande dans lequel la boucle de rétroaction se situe à l'intérieur du dispositif d'amplification 15. Cela permet de stabiliser ce dispositif 15.

On notera que l'exemple de réalisation du dispositif décrit plus haut à la Fig. 4 peut être utilisé dans ce schéma fonctionnel également.

La Fig. 9 illustré un deuxième exemple de réalisation du dispositif de commande. Comme dans le cas du premier exemple de réalisation de la Fig. 4, il peut être utilisé dans les trois schémas fonctionnels non limitatifs de la Fig. 2, 3 et 8.

Bien entendu, ces deux exemples de réalisation peuvent être utilisés dans d'autres schémas fonctionnels et d'autres applications, en particulier quand on veut remplacer une diode par une diode idéale (ayant moins de pertes), et d'autant plus si le courant à redresser a une pente de variation faible.

On va décrire ci-après le deuxième exemple de réalisation de la Fig. 9.

Le dispositif d'amplification 15 comprend également :
- Un premier étage d'amplification PD,
- un deuxième étage d'amplification AS,
- un troisième étage d'amplification AT, et
- un étage de commande en tout ou rien ON/OFF

Ces quatre éléments sont décrits en détail ci-après.

On notera que les composants ayant les mêmes références que dans le premier exemple de réalisation de la Fig. 4 sont de même type que ceux dans ce premier exemple. On ne les décrira donc pas.
o Premier étage d'amplification PD : on a juste enlevé la diode D10.
o Deuxième étage d'amplification AS :
   Il comprend :
      - une résistance R103 (à la place de R21, R22 T27 T28 R14). Elle a la même fonction que les composants qu'elle remplace,
      - les diodes D5 et D6 du troisième étage AT du premier exemple de réalisation qui ont été introduites dans ce deuxième étage AS.
      - Une rétroaction R110-C103 qui permet de stabiliser tout le dispositif d'amplification 15 de manière plus efficace que la capacité C8 du premier exemple de réalisation.
         o Troisième étage d'amplification AT :
   Il comprend :
      - un ensemble résistance R108-diode D103 remplaçant l'ensemble résistances R10-R30 du premier exemple de réalisation. Cet ensemble résistance-diode outre d'assurer la même fonction que l'ancien ensemble, permet d'éviter un écart de tension entre les deux transistors T26 et T20 et donc de commander plus rapidement la grille du transistor MOS 5 en particulier lors de la décharge de la grille.

Il ne comprend plus le sous-ensemble T21-T22-R11-C4, qui a été remplacé par une liaison directe sur le transistor T29. Cette solution est plus simple et permet de consommer moins de courant.

### o Etage de commande en tout ou rien ON/OFF

Il comprend :
- deux entrées recevant un premier signal COFF permettant d'éteindre le transistor 5 et un deuxième signal CONN permettant d'allumer le transistor 5.
- Ces signaux de tension sont convertis en courant par respectivement les ensembles T114-R122 et T113-R123,
- deux miroirs de courant T102-R104-R105-T101 et T104-R106-R107-T103 permettent de recopier le courant dans les résistances R113 et R114 de façon à commander en tout ou rien les transistors T111 et T112, respectivement.
- Les transistors T111 et T112 permettent de commander en tout ou rien le transistor MOS 5

On notera que l'étage de commande utilise le troisième étage d'amplification AT. Cela simplifie le schéma électrique et permet de la place sur le silicium lorsque le dispositif de commande est intégré sur un ASIC et de réduire le nombre de composants lorsqu'il n'est pas intégré.

On notera que cet étage complémentaire peut être utilisé dans l'application batterie décrite pour connecter en parallèle les deux batteries lors d'un démarrage (mode moteur), et notamment par grand froid car par grand froid, la puissance disponible par batterie est réduite. La connexion des deux batteries en parallèle permet d'obtenir une augmentation de puissance au démarrage.

Le dispositif de commande 10 selon l'invention a été décrit dans le cadre de l'application batterie décrite ci-dessus selon le premier exemple ou le deuxième exemple de réalisation. Bien entendu les applications batterie ne sont pas les seules concernées par le dispositif de commande 10 selon l'invention. Il peut s'appliquer à toute autre application dans laquelle notamment il est utile de diminuer les pertes joules dues à un courant traversant une diode.

Ainsi, le dispositif de commande 10 peut s'appliquer à un pont redresseur, notamment la partie commandant le transistor 5. En particulier, de manière non limitative, il s'applique pour un pont redresseur d'un alternateur ou d'un alterno-démarreur, ledit pont redressant le courant généré par l'alternateur pour l'utiliser en continu pour des consommateurs de véhicule.

Grâce à l'étage de commande en tout ou rien ON/OFF du deuxième exemple de réalisation du dispositif de commande, on peut également utiliser le dispositif de commande 10 pour un onduleur permettant de commander la machine électrique en mode moteur, ledit onduleur permettant de transformer un courant continu en un courant alternatif qui permet de générer un couple moteur.

En général un tel pont/onduleur comporte trois bras comprenant chacun deux transistors MOS et étant relié chacun à une phase du stator de l'alternateur ou alterno-démarreur. Le dispositif de commande décrit précédemment est défini pour un transistor 5 d'un bras du pont/onduleur. On aura donc six dispositifs de commande 10 associés à un pont/onduleur.

Tel qu'illustré à la Fig. 10, on peut voir que dispositif de commande 10 est relié à une phase de l'alternateur ou la masse de l'alternateur selon que ledit dispositif pilote le transistor du bas « low side » ou du haut « high side » d'un bras du pont de puissance (redresseur/onduleur).

La suite de la description porte sur un pont redresseur.

Pour un pont redresseur, le courant initial étant alternatif, il passe régulièrement d'une valeur négative à une valeur positive. Ce courant est représentatif du courant drain-source Ids passant dans le transistor 5. De ce fait, si on ouvre le transistor 5 trop lentement, le courant Ids s'inversera avant ladite ouverture, ce qui provoquera des oscillations sur la tension Vds. Cela est susceptible de générer des parasites électromagnétiques CEM perturbant le fonctionnement des consommateurs du véhicule.

Aussi, il est nécessaire d'ouvrir rapidement le transistor 5. Plus la pente de variation de Ids est grande plus il faut ouvrir rapidement le transistor.

Ainsi, la Fig. 7 illustre deux variations différentes du courant drain-source Ids de pente Ids1 et Ids2 respectivement, en fonction du temps d'ouverture du transistor 5.

On peut voir dans le cas d'une pente douce Ids2, le transistor 5 est ouvert avant le changement de signe du courant drain-source Ids, tandis que dans le cas d'une forte pente Ids1, le transistor 5 s'ouvre après ledit changement de signe, et s'ouvre pendant l'intervalle de temps indiqué TOFF. Dans ce dernier cas, il y a un pic de courant P suivi d'oscillations d'amortissement sur la tension drain-source Vds. Ces oscillations vont se répéter à chaque alternance du courant initial.

Le problème de ces oscillations est avantageusement résolu par le dispositif de commande 10 selon l'invention. En effet, la tension grille-source Vgs est déjà proche de la tension limite de commande du transistor Vth = 3v avant l'ouverture du transistor 5, car on est en régime linéaire comme vu précédemment. Donc, la commande du transistor 5 est plus rapide à effectuer On passe d'un état linéaire à l'état ouvert au lieu de passer d'un état fermé à l'état ouvert.

On notera que la rapidité de commande est améliorée grâce également aux trois étages d'amplification PD, AS, et AT, comme vu précédemment.

On notera également que les étages d'amplification peuvent comprendre de plus un correcteur afin d'améliorer encore les caractéristiques dynamiques de ce pilotage de transistor. Par exemple, on peut améliorer la dynamique et la rapidité du dispositif au moyen d'un correcteur à intégration ou autre.

Ainsi, le dispositif de commande 10 selon l'invention présente les avantages suivants :
- en raison de l'utilisation de courants en entrée du premier étage PD (et non de tensions), ce dispositif est robuste vis-à-vis des interférences qui pourraient perturber le dispositif de commande. On peut donc utiliser un tel dispositif de commande dans un environnement soumis à de fortes perturbations électromagnétiques ou dans un réseau bruité.
- Un tel dispositif de commande ne fait pas intervenir nécessairement d'amplificateurs opérationnels ou similaires. Ces derniers sont limités par notamment leur pente de variation de la tension de sortie (couramment appelée en anglais « slew-rate »), leur bande passante, les conditions d'utilisation en température, leur tension de sortie ne pouvant descendre jusqu'à zéro volts ou jusqu'à 15V pour piloter le transistor 5 MOS à l'état totalement passant ou totalement ouvert. Ainsi, on n'est pas limité dans la fabrication d'un tel dispositif.

- un tel dispositif de commande est de structure simple. Donc, il comporte un nombre faible de composants de base et peut donc facilement être intégrable dans un ASIC sans trop prendre de place. Cela assure un coût peu élevé, avec possibilité d'industrialisation simple. Par ailleurs, le fait qu'il prenne peu de place, permet d'intégrer facilement le transistor 5 MOS dans le même ASIC. On peut ainsi facilement adapter la technologie de fabrication du dispositif de commande dans un ASIC à la technologie de fabrication du transistor MOS sans prendre trop de place par rapport à un amplificateur opérationnel standard, qui lui comprend environ une quarantaine de transistors.
- Un tel dispositif de commande permet une bonne stabilité en température. En effet, le fonctionnement d'un tel dispositif est toujours le même que ce soit à 25°C ou à 125°C par exemple. Ceci grâce au fait que la structure du premier étage d'amplification PD est symétrique.
- Le dispositif de commande peut supporter des hautes tensions et mesurer ainsi des tensions drain-source élevées, par exemple supérieures à 500V. En effet, les diodes de protection D9, D4, et D3 associées respectivement à la boucle de rétroaction et aux entrées du dispositif d'amplification permettent d'encaisser ces surtensions, de sorte que l'ensemble des transistors est protégés.
- Il n'existe aucun courant de fuite si le dispositif de commande est éteint (Vcc=0V) de sorte que les batteries ne se déchargent pas lorsque le véhicule est à l'arrêt. Ceci grâce également aux diodes de protection D4, D3, et D9.
- Le décalage de mesure en tension est fixé par une source de tension D7 et un rapport de résistances R9/(R13+R7), ou une source de courant et la première résistance R9, ce qui implique une faible dérive en température du dispositif de commande. En conséquence l'intégration dans un ASIC est plus facile. En effet, dans un circuit intégré, il y a une dérive en température qui implique que le silicium du circuit intégré conduit plus ou moins bien en fonction de la température. Pour éviter cette dérive en température, il faut obtenir un rapport de résistances constant, les valeurs des résistances pouvant varier, ce qui est obtenu grâce au dispositif de l'invention. Au contraire, en composants discrets, il est nécessaire d'obtenir des valeurs de résistances fixes, ce qui est plus difficile à obtenir.
- On a uniquement une alimentation positive Vcc référencée par rapport au noeud N pour tout le dispositif ce qui supprime une alimentation par rapport à un cas avec un amplificateur opérationnel classique nécessitant une alimentation supplémentaire négative. Cette alimentation peut être commune avec le dispositif de commande en tout ou rien du transistor 4.
- On obtient une tension de référence positive au moyen d'un courant de référence et de deux résistances R9 et R18., ce qui est plus facile à réaliser qu'une tension de référence négative. Dans ce dernier cas, il est en effet nécessaire d'avoir deux sources d'alimentation, une négative, et une positive.
- La commande du transistor 5 est réalisée très rapidement. En effet, l'entrée du signal de tension drain Vd entre directement sur l'émetteur du transistor bipolaire T1 de la paire différentielle PD. Ceci permet d'obtenir une impédance d'entrée faible, un gain faible et donc une forte bande passante. Le courant de base est faible de sorte que le courant collecteur est égal au courant émetteur ic = ie. En conséquence, quand la tension drain Vd varie, le courant de commande Icom varie. Comme ce dernier est fort, il n'est pas nécessaire de beaucoup l'amplifier pour piloter le transistor 5, contrairement à un agencement dans lequel le signal de tension drain Vd entrerait sur la base du transistor bipolaire T1. Dans ce dernier cas, on aurait le courant base inférieur au courant émetteur ib < ie et on serait obligé d'amplifier le courant de commande Icom avant le pilotage du transistor 5.
- Le fait d'avoir les courants de polarisation intégrés dans le dispositif d'amplification évite d'avoir une consommation de courant sur l'alimentation Vcc supplémentaire en sus de la consommation propre des étages d'amplification.
- Grâce à la capacité C8, on peut fixer une pente maximale de variation sur la tension de sortie grille-source Vgs appelé an anglais « slew rate » de manière à améliorer la stabilité du dispositif de commande.
- L'utilisation d'une résistance de l'ordre de 100kΩ (R18) pour la boucle de rétroaction au lieu d'une forte résistance de l'ordre de 1MΩ est plus facilement intégrable dans un ASIC. Par ailleurs, quand le dispositif de commande est réalisé en composants discrets, si de l'humidité s'infiltre, il est bon d'avoir des résistances de faible valeur pour éviter une variation des valeurs desdites résistances en raison de l'eau.
- Grâce aux diodes de protection D4, D3, et D9, on évite les courants de fuite. Ceci a pour autre avantage d'éviter une oxydation des phases du stator de l'alternateur dans le cas de l'application pont redresseur, l'alternateur étant dans un milieu souvent humide favorisant la corrosion. En effet, en cas de présence de courants de fuite, une différence de potentiel existe entre les phases et la carcasse de l'alternateur reliée à la masse du véhicule.
- Ce dispositif de commande 10 permet d'éviter les effets négatifs (tension négative sur tous les consommateurs) sur le réseau de bord d'une inversion de polarité de la batterie 2. La tension de la batterie 2 devient inférieure à celle de la batterie 3, le transistor 5 s'ouvre alors avant qu'une intensité négative ne circule.
- Le dispositif de commande est simple et donc facilement intégrable dans un circuit intégré ASIC ou directement sur le même substrat que le transistor de puissance MOS. On peut également mettre plusieurs dispositifs de commande sur le même substrat ou dans un même ASIC pour commander plusieurs transistors MOS (par exemple un dispositif qui commande un bras de pont de puissance, ou encore l'ensemble des bras du pont etc...).

## Revendications

1. Dispositif de commande (10) d'un transistor de puissance (5) formé d'un canal comprenant une grille, une source, et un drain, ledit dispositif comportant :
- un dispositif d'amplification (15) délivrant un signal de commande de sortie pour contrôler la grille du transistor de puissance (5), ledit dispositif d'amplification comprenant :
- une première entrée (NEG) reliée au drain du transistor via une première résistance (R9), le tout formant une première portion de circuit,
- une deuxième entrée (POS) reliée à la source du transistor, le tout formant une deuxième portion de circuit, et
- une boucle de rétroaction avec au moins une résistance (R18) de la sortie vers une des première et deuxième entrées (NEG, POS) ; et
un moyen pour produire un courant de polarisation (I1,I2), ledit courant étant injecté dans une des dites première et deuxième entrées (NEG, POS) de manière à provoquer un décalage de la mesure de tension drain-source et conserver un régime de fonctionnement linéaire dudit signal de commande de sortie, avant l'ouverture du transistor ;
**caractérisé en ce que** le dispositif de commande comporte un même nombre N de jonctions semi-conductrices dans les première et deuxième portions de circuit, N étant un entier au moins égal à 1, et la (les) jonction(s) sur la première portion de circuit est de même nature que celle(s) sur la deuxième portion de circuit.

2. Dispositif de commande d'un transistor de puissance (5), selon l'une des revendications précédentes, **caractérisé en ce qu'**il comporte deux moyens pour produire deux courants de polarisation (I1, I2), les deux courants étant injectés aux entrées (NEG, POS) du dispositif d'amplification (15).

3. Dispositif de commande d'un transistor de puissance (5) selon la revendication précédente, caractérisé en que les deux courants de polarisation (I1, I2) traversent respectivement des dispositifs de protection (D4, D3) des première et deuxième portions de circuit.

4. Dispositif de commande d'un transistor de puissance (5), selon l'une des revendications précédentes, **caractérisé en ce que** le courant de polarisation est intégré dans le dispositif d'amplification (15).

5. Dispositif de commande d'un transistor de puissance (5), selon l'une des revendications précédentes 1 à 4, **caractérisé en ce qu'**il comporte un dispositif de protection (D9) sur la boucle de rétroaction (16).

6. Dispositif de commande d'un transistor de puissance (5), selon l'une des revendications précédentes, **caractérisé en ce que** le dispositif d'amplification (15) comprend un premier étage d'amplification (PD) pour amplifier la tension d'entrée (Vds+R9*I2) du dispositif d'amplification (15) et le courant de polarisation (I1, I2) traverse le premier étage d'amplification (PD).

7. Dispositif de commande d'un transistor de puissance (5) selon la revendication 6, **caractérisé en ce que** le dispositif d'amplification (15) comprend un deuxième étage d'amplification (AS) pour amplifier la tension du premier étage d'amplification (PD).

8. Dispositif de commande d'un transistor de puissance (5), selon l'une des revendication précédentes, **caractérisé en ce que** le dispositif d'amplification (15) comporte un troisième étage d'amplification (AT) comportant un gain en courant important de façon à commander rapidement le transistor (5), et ledit troisième étage d'amplification comprend un circuit de décharge (DECH) rapide du transistor (5), le circuit de décharge (DECH) comprenant des moyens (T20-T21-T22; D103-T20-R108) pour décharger jusqu'à sensiblement zéro la grille du transistor (5).

9. Dispositif de commande d'un transistor de puissance (5), selon la revendication 8, **caractérisé en ce que** ledit troisième étage d'amplification (AT) comprend un circuit de charge (CHAR) du transistor (5).

10. Dispositif de commande d'un transistor de puissance (5), selon l'une des revendications précédentes, **caractérisé en ce que** le dispositif d'amplification (15) comporte un étage de commande supplémentaire (ON/OFF) pour commander en tout ou rien un transistor de puissance (4 ;5), l'étage de commande (ON/OFF) en tout ou rien utilisant le troisième étage d'amplification (AT).

11. Machine électrique tournante comprenant un dispositif de commande d'un transistor de puissance selon l'une des revendications 1 à 10 apte à piloter ladite machine en mode moteur.

## Patentansprüche

1. Vorrichtung (10) zur Steuerung eines Leistungstransistors (5), der aus einem Kanal gebildet ist, der ein Gate, eine Source und einen Drain aufweist, wobei die Vorrichtung Folgendes aufweist:
- eine Verstärkungsvorrichtung (15), die ein Ausgangssteuersignal zum Steuern des Gates des Leistungstransistors (5) liefert, wobei die Verstärkungsvorrichtung Folgendes aufweist:
- einen ersten Eingang (NEG), der über einen ersten Widerstand (R9) mit dem Drain des Transistors verbunden ist, wobei das Ganze einen ersten Schaltungsabschnitt bildet,
- einen zweiten Eingang (POS), der mit der Source des Transistors verbunden ist, wobei das Ganze einen zweiten Schaltungsabschnitt bildet, und
- eine Rückkopplungsschleife mit mindestens einem Widerstand (R18) des Ausgangs in Richtung von dem ersten oder dem zweiten Eingang (NEG, POS); und
- ein Mittel zum Erzeugen eines Polarisationsstroms (I1, I2), wobei der Strom derart in den ersten oder den zweiten Eingang (NEG, POS) eingespeist wird, dass vor der Öffnung des Transistors ein Versatz der Messung der Drain-Source-Spannung bewirkt und ein linearer Betrieb des Ausgangssteuersignals bewahrt wird;
**dadurch gekennzeichnet, dass** die Steuervorrichtung eine selbe Anzahl N von Halbleiterübergängen in dem ersten und dem zweiten Schaltungsabschnitt aufweist, wobei N eine ganze Zahl mindestens gleich 1 ist und der/die Übergang/Übergänge auf dem ersten Schaltungsabschnitt dieselbe Beschaffenheit aufweist/aufweisen wie derjenige/diejenigen auf dem zweiten Schaltungsabschnitt.

2. Vorrichtung zur Steuerung eines Leistungstransistors (5) nach Anspruch 1, **dadurch gekennzeichnet, dass** er zwei Mittel zum Erzeugen von zwei Polarisationsströmen (I1, 12) aufweist, wobei die zwei Ströme in die Eingänge (NEG, POS) der Verstärkungsvorrichtung (15) eingespeist werden.

3. Vorrichtung zur Steuerung eines Leistungstransistors (5) nach dem vorhergehenden Anspruch, **dadurch gekennzeichnet, dass** die zwei Polarisationsströme (I1, 12) jeweils Schutzvorrichtungen (D4, D3) des ersten und zweiten Schaltungsabschnitts durchfließen.

4. Vorrichtung zur Steuerung eines Leistungstransistors (5) nach einem der vorhergehenden Ansprüche, **dadurch gekennzeichnet, dass** der Polarisationsstrom in die Verstärkungsvorrichtung (15) integriert ist.

5. Vorrichtung zur Steuerung eines Leistungstransistors (5) nach einem der vorhergehenden Ansprüche 1 bis 4, **dadurch gekennzeichnet, dass** sie eine Schutzvorrichtung (D9) auf der Rückkopplungsschleife (16) aufweist.

6. Vorrichtung zur Steuerung eines Leistungstransistors (5) nach einem der vorhergehenden Ansprüche, **dadurch gekennzeichnet, dass** die Verstärkungsvorrichtung (15) eine erste Verstärkerstufe (PD) zum Verstärken der Eingangsspannung (Vds + R9 * 12) der Verstärkungsvorrichtung (15) aufweist und der Polarisationsstrom (I1, 12) die erste Verstärkerstufe (PD) durchfließt.

7. Vorrichtung zur Steuerung eines Leistungstransistors (5) nach Anspruch 6, **dadurch gekennzeichnet, dass** die Verstärkungsvorrichtung (15) eine zweite Verstärkerstufe (AS) zum Verstärken der Spannung der ersten Verstärkerstufe (PD) aufweist.

8. Vorrichtung zur Steuerung eines Leistungstransistors (5) nach einem der vorhergehenden Ansprüche, **dadurch gekennzeichnet, dass** die Verstärkungsvorrichtung (15) eine dritte Verstärkerstufe (AT) aufweist, die eine große Stromverstärkung aufweist, derart, dass der Transistor (5) schnell gesteuert wird, und die dritte Verstärkerstufe eine Schnellentladeschaltung (DECH) des Transistors (5) aufweist, wobei die Entladeschaltung (DECH) Mittel (T20-T21-T22; D103-T20-R108) zum Entladen des Gates des Transistors (5) bis auf im Wesentlichen null aufweist.

9. Vorrichtung zur Steuerung eines Leistungstransistors (5) nach Anspruch 8, **dadurch gekennzeichnet, dass** die dritte Verstärkerstufe (AT) eine Ladeschaltung (CHAR) des Transistors (5) aufweist.

10. Vorrichtung zur Steuerung eines Leistungstransistors (5) nach einem der vorhergehenden Ansprüche, **dadurch gekennzeichnet, dass** die Verstärkungsvorrichtung (15) eine zusätzliche Steuerstufe (ON/OFF) für die Ein-Aus-Steuerung eines Leistungstransistors (4; 5) aufweist, wobei die Ein-Aus-Steuerstufe (ON/OFF) die dritte Verstärkerstufe (AT) verwendet.

11. Umlaufende elektrische Maschine, die eine Vorrichtung zur Steuerung eines Leistungstransistors nach einem der Ansprüche 1 bis 10 aufweist, die geeignet ist, die Maschine im Motormodus zu steuern.

## Claims

1. Control device (10) for controlling a power transistor (5) formed of a channel comprising a gate, a source, and a drain, the said device comprising:
- an amplification device (15) delivering an output control signal in order to control the gate of the power transistor (5), the said amplification device comprising:
- a first input (NEG) connected to the drain of the transistor via a first resistor (R9), the assembly forming a first circuit portion,
- a second input (POS) connected to the source of the transistor, the assembly forming a second circuit portion, and
- a feedback loop with at least one resistor (R18) from the output to one of the first and second inputs (NEG, POS); and
a means for producing a bias current (I1, 12), the said current being injected into one of the said first and second inputs (NEG, POS) so as to cause an offset of the drain-source voltage measurement and maintain a linear operating regime of the said output control signal, before the opening of the transistor;
**characterized in that** the control device comprises one and the same number N of semi-conducting junctions in the first and second circuit portions, N being an integer at least equal to 1, and the junction(s) on the first circuit portion is (are) of the same kind as that (those) on the second circuit portion.

2. Control device for controlling a power transistor (5) according to Claim 1, **characterized in that** it comprises two means for producing two bias currents (I1, 12), the two currents being injected at the inputs (NEG, POS) of the amplification device (15).

3. Control device for controlling a power transistor (5) according to the preceding claim, **characterized in that** the two bias currents (I1, 12) traverse respectively protective devices (D4, D3) of the first and second circuit portions.

4. Control device for controlling a power transistor (5) according to one of the preceding claims, **characterized in that** the bias current is incorporated into the amplification device (15).

5. Control device for controlling a power transistor (5) according to one of the preceding Claims 1 to 4, **characterized in that** it comprises a protective device (D9) on the feedback loop (16).

6. Control device for controlling a power transistor (5) according to one of the preceding claims, **characterized in that** the amplification device (15) comprises a first amplification stage (PD) to amplify the input voltage (Vds+R9*I2) of the amplification device (15) and the bias current (I1, 12) traverses the first amplification stage (PD).

7. Control device for controlling a power transistor (5) according to Claim 6, **characterized in that** the amplification device (15) comprises a second amplification stage (AS) to amplify the voltage of the first amplification stage (PD).

8. Control device for controlling a power transistor (5) according to one of the preceding claims, **characterized in that** the amplification device (15) comprises a third amplification stage (AT) comprising a considerable current gain so as to rapidly control the transistor (5), and the said third amplification stage comprises a rapid discharge circuit (DECH) of the transistor (5), the discharge circuit (DECH) comprising means (T20-T21-T22; D103-T20-R108) in order to discharge the gate of the transistor (5) to substantially zero.

9. Control device for controlling a power transistor (5) according to Claim 8, **characterized in that** the said third amplification stage (AT) comprises a charging circuit (CHAR) for charging the transistor (5).

10. Control device for controlling a power transistor (5) according to one of the preceding claims, **characterized in that** the amplification device (15) comprises an additional control stage (ON/OFF) to switch on or off a power transistor (4; 5), the on/off control stage (ON/OFF) using the third amplification stage (AT).

11. Electrical rotating machine comprising a control device for controlling a power transistor according to one of Claims 1 to 10, capable of controlling the said machine in drive mode.
